# Europäisches Patentamt

# European Patent Office

# Office européen des brevets

(11) Publication number: **0 088 134**
**B1**

# EUROPEAN PATENT SPECIFICATION

(45) Date of publication of patent specification: **06.08.86**

(51) Int. Cl.⁴: **H 04 N 5/30**

(21) Application number: **82902747.3**

(22) Date of filing: **17.09.82**

(86) International application number:
**PCT/JP82/00374**

(87) International publication number:
**WO 83/01170 31.03.83 Gazette 83/08**

(54) **SOLID STATE IMAGE PICKUP DEVICE.**

(30) Priority: **17.09.81 JP 146873/81**

(43) Date of publication of application:
**14.09.83 Bulletin 83/37**

(45) Publication of the grant of the patent:
**06.08.86 Bulletin 86/32**

(84) Designated Contracting States:
**DE FR GB NL**

(56) References cited:
**JP-A-55 163 960**
**JP-A-55 163 961**
**JP-A-56 100 577**

**INTERNATIONAL CONFERENCE ON CHARGE COUPLED DEVICES, TECHNOLOGY AND APPLICATION OF CHARGE DEVICES, San Diego, October 29-31, 1975, EDINBURGH (GB) K.A. HOAGLAND et al.: "CCD-TV cameras utilizing interline-transfer area image sensors", pages 173-180**

(73) Proprietor: **SONY CORPORATION**
**7-35 Kitashinagawa 6-Chome Shinagawa-ku Tokyo 141 (JP)**

(72) Inventor: **TAKESHITA, Kaneyoshi Atsugi Plant, Sony Corp.**
**14-1 Asahi-cho 4-chome Atsugi-shi Kanagawa-ken 243 (JP)**

(74) Representative: **Cotter, Ivan John et al D. YOUNG & CO. 10 Staple Inn London WC1V 7RD (GB)**

## Description

This invention relates to solid state image pickup apparatus employing a solid state image pickup device.

Solid state image pickup devices comprising a charge transfer device such as a charge coupled device (hereinafter referred to as a CCD) are classified broadly into the frame transfer type and the interline transfer type, and each of them is utilised in a different way so as to make good use of its advantages and features. One example of a solid state image pickup device of the interline transfer type using CCDs comprises a photo-sensing and vertical transfer portion which includes a plurality of photodetectors arranged in horizontal and vertical rows and vertical transfer portions each formed with a group of CCDs and extending along each of the vertical rows of the photodetectors, a horizontal transfer portion coupled with the photo-sensing and vertical transfer portion, and an output portion coupled with the horizontal transfer portion and provided with a signal output terminal, the whole of which are formed on a common semiconductor substrate.

In a solid state image pickup apparatus employing such a solid state image pickup device of the interline transfer type using CCDs, a vertical driving signal for vertical charge transfer is applied to the vertical transfer portions through vertical transfer electrodes which are provided on an insulating layer lying over the photo-sensing and vertical transfer portion and a horizontal driving signal for horizontal charge transfer is applied to the horizontal transfer portion through horizontal charge transfer electrodes which are provided on an insulating layer lying over the horizontal transfer portion, so that a vertical charge transfer operation and a horizontal charge transfer operation are performed in the vertical transfer portions and the horizontal transfer portion, respectively. For example, signal charges produced in the photodetectors in response to light received thereby during one frame period are read out to the vertical transfer portions, and then transferred towards the horizontal transfer portion by the vertical charge transfer operation performed in the vertical transfer portion so that the signal charges produced in each horizontal row of the photodetectors are transferred in turn to the horizontal transfer portion. The signal charges transferred to the horizontal transfer portion are further transferred to the output portion by the horizontal charge transfer operation performed in the horizontal transfer portion and, as a result of this, an image pickup signal output is obtained at the signal output terminal.

When a picture is reproduced from an image pickup signal output obtained from a solid state image pickup device of the interline transfer type as described above used in a previously proposed solid state image pickup apparatus described in more detail hereinbelow, a defect in the form of a pair of black and white spots that are contiguous to each other in the up and down direction appears on the reproduced picture. This defect is usually called "white and black spots", and the black spot therein tends to become elongate when the image pickup signal output is produced under relatively low illuminance. Such white and black spots cannot be eliminated by means of ordinary defect correction, because they result from a local area of deep (high) potential residing in the vertical transfer portion. This local area of deep potential in the vertical transfer portion appears at a region having high impurity density which is provided (undesirably) due to nonuniformity in impurity density in the vertical transfer portion, or at a region positioned under a thick portion of the insulating layer which is provided (undesirably) due to nonuniformity in thickness of the insulating layer on the vertical transfer portion, and is a structural defect in the image pickup device.

In the case of an image pickup device having such a local area of deep potential in the vertical transfer portion as described above, an insulated gate field effect transistor (hereinafter referred to as a MOS FET) having its source at the local area of deep potential is substantially formed in the vertical transfer portion and a flow of charges is caused from the local area of deep potential to an advanced potential well in the vertical transfer portion as a sub-threshold current of the MOS FET. If a charge transfer period in which each charge transfer in the vertical transfer portions is carried out is constant and the manner of repetition of such charge transfer periods is made uniform, the amount of charges flowing into the advanced potential well from the local area of deep potential does not vary and, therefore, the charges flowing into the advanced potential well from the local area of deep potential do not raise any serious problem.

However, with regard to the charge transfer operation in the vertical transfer portions, an exceptional situation in which the charge transfer period is elongated in comparison with that in the normal situation arises, for example, once per frame period, and, during such elongated charge transfer period, the local area of deep potential sends the charges stored therein in large quantities into the advanced potential well so as to supply excessive signal charges to the latter and, on the contrary, to make areas positioned behind be lacking in signal charges. This leads to the result that the signal charges are in unbalanced quantities so that an image pickup signal output developed therefrom is deteriorated and the white and black spots appear on a picture reproduced from the deteriorated image pickup signal output.

A solid state image pickup apparatus is described in an article by K A Hoagland et al which is entitled "CCD—TV Cameras Utilizing Interline-Transfer Area Image Sensors" and which appears at pages 173—180 of INTERNATIONAL CONFERENCE ON CHARGE COUPLED DEVICES, TECHNOLOGY AND APPLICATION OF CHARGE COUPLED DEVICES, San Diego, 29—31 October 1975, University of Edinburgh, Edinburgh, Scotland, 1975. This article appears to describe solid state image pickup apparatus comprising: a solid state image pickup device which comprises a plurality of photodetectors arranged horizontally and vertically, a plurality of transfer gate areas each corresponding to one of the photodetectors, a plurality of vertical transfer portions each extending vertically and positioned contiguously to the transfer gate areas to receive signal charges transferred from alternate rows of the photodetectors spaced in the vertical direction during successive field periods, an output portion, and a horizontal transfer portion coupled to an end of each of the vertical transfer portions to receive the signal charges from the vertical transfer portions and to transfer the charges to the output portion; and means for generating a signal to cause transfer of the signal charges from the photodetectors to the vertical transfer portions and thence to the horizontal transfer portion. No solution to the problem of black and white spots appears to be disclosed in the article.

In view of the cause of the white and black spots explained above, it is understood that the problem of the white and black spots can be solved by maintaining constant the charge transfer period, in which each charge transfer in the vertical transfer portions is carried out, regardless of the operation for reading out the signal charges to the vertical transfer portions from the photodetectors.

Accordingly, it is an object of the present invention to provide a solid state image pickup apparatus employing a solid state image pickup device of the interline transfer type, in which the charge transfer performed in the vertical transfer portions of the solid state image pickup device is improved so that a charge transfer period in which each charge transfer in the vertical transfer portions is carried out is made uniform and, consequently, an image pickup signal output from which a picture without the defect usually called "white and black spots" can be reproduced can be obtained from the apparatus.

According to the present invention there is provided a solid state image pickup apparatus comprising:

a solid state image pickup device which comprises a plurality of photodetectors arranged horizontally and vertically, a plurality of transfer gate areas each corresponding to one of the photodetectors, a plurality of vertical transfer portions each extending vertically and positioned contiguously to the transfer gate areas to receive signal charges transferred from alternate rows of the photodetectors spaced in the vertical direction during successive field periods, an output portion, and a horizontal transfer portion coupled to an end of each of the vertical transfer portions to receive the signal charges from the vertical transfer portions and to transfer the charges to the output portion; and means for generating a signal to cause transfer of the signal charges from the photodetectors to the vertical transfer portions and thence to the horizontal transfer portion;

characterised in that the signal generating means is operative such that a reading pulse voltage of a first high level is applied to each of two of the transfer gate areas adjacent in the vertical direction alternately at every field period so that signal charges are read out to storage regions of the vertical transfer portions from the photodetectors corresponding to the transfer gate areas to which the reading pulse voltage is applied, a voltage of a second high level lower than the first high level is applied to the storage regions of the vertical transfer portions during each horizontal video period, and transfer pulse voltages adopting a low level in turn at respective different phases within each horizontal blanking period are applied to the vertical transfer portions so that the signal charges read out to the vertical transfer portions are transferred vertically to the horizontal transfer portion.

With a solid state image pickup apparatus thus constituted in accordance with the present invention, even if the solid state image pickup device of the interline transfer type employed therein contains a defective local area having deep potential in the vertical transfer portions, an image pickup signal output, which is produced in a frame interlaced reading manner and does not cause a defect on a picture reproduced therefrom which otherwise would result from the defective local area in the image pickup device, can be obtained. Further, since an image pickup device containing such a defective local area can be used as a normal device, the yield rate in manufacturing is substantially improved. Moreover, since the rate at which vertical driving signal supplied at respective different phases to the vertical transfer portions of the image pickup device adopt a high level voltage is increased, an additional effect can be obtained that an overflow drain formed with a buried channel in the image pickup device is stabilised in its operation and smears arising in the first and second field periods constituting each frame period are reduced to an average so that the difference in brightness between each two field pictures reproduced in response to the image pickup signal output derived from the apparatus is reduced.

The invention will now be further described, by way of illustrative and non-limiting example, with reference to the accompanying drawings, in which:—

Figure 1 is a schematic plan view showing an example of a solid state image pickup device of the interline transfer type comprising a charge coupled device (CCD);

Figure 2A is a plan view on an enlarged scale of a portion of the device shown in Figure 1;

Figure 2B is a sectional view taken along a line IIB—IIB in Figure 2A;

Figures 3A and 3B are waveform diagrams showing an example of a set of driving signals used for photo-sensing and vertical transfer portion of a solid state image pickup device employed in a previously proposed solid state image pickup apparatus;

Figure 4 is a sectional view showing a portion of another example of a solid state image pickup device of the interline transfer type comprising a CCD;

Figures 5A, 5B and 5C are waveform diagrams showing another example of a set of driving signals used for a photo-sensing and vertical transfer portion of a solid state image pickup device employed in a previously proposed solid state image pickup apparatus;

Figure 6 is an illustration used for explaining the occurrence of a defect comprising white and black spots;

Figures 7A, 7B, 8A and 8B are waveform diagrams showing a set of driving signals used for a photo-sensing and vertical transfer portion of a solid state image pickup device employed in an embodiment of the present invention;

Figure 9 is a plan view showing on an enlarged scale a portion of a solid state image pickup device employed in another embodiment of the present invention; and

Figures 10A, 10B, 10C and 10D are waveform diagrams showing a set of driving signals used for a photo-sensing and vertical transfer portion of the solid state image pickup device of which a portion is shown in Figure 9.

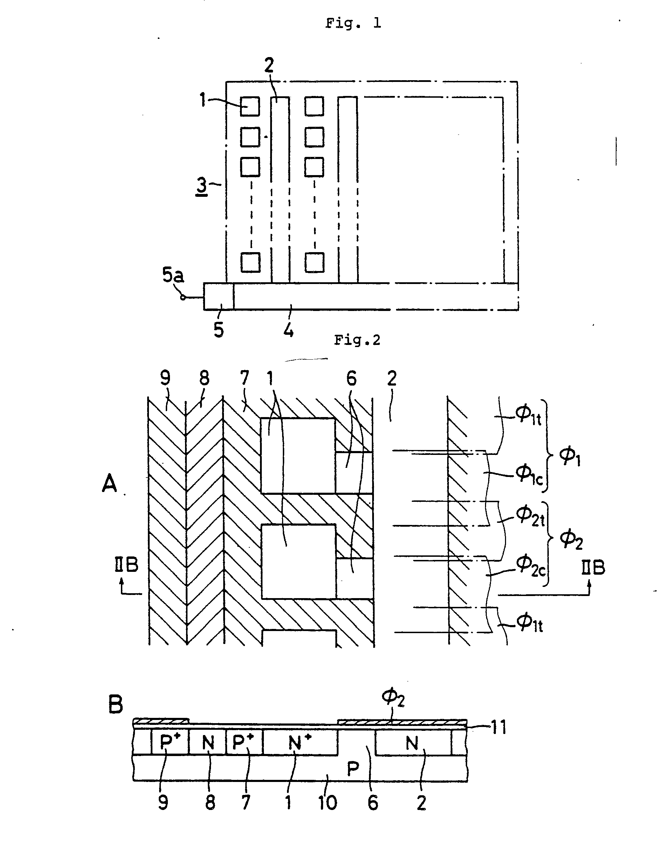

First, to facilitate understanding of embodiments of the present invention described below, the configuration of a solid state image pickup device of the interline transfer type and the operation of such a solid state image pickup device employed in a previously proposed solid state image pickup apparatus will be explained with reference to Figures 1 to 6.

An example of a solid state image pickup device of the interline transfer type using a charge coupled device (CCD) is constituted as shown in Figure 1. The device comprises a photo-sensing and vertical transfer portion 3 which includes a plurality of photodetectors 1 arranged in horizontal and vertical rows and vertical transfer portions 2 each formed with a group of CCDs and provided along each of the vertical rows of the photodetectors 1, a horizontal transfer portion 4 coupled with the photo-sensing and vertical transfer portion 3, and an output portion 5 coupled with the horizontal transfer portion 4 and provided with a signal output terminal 5a, the whole of which is formed on a common semiconductor substrate.

In a solid state image pickup apparatus employing such a solid state image pickup device as just described, a predetermined vertical transfer driving signal and a predetermined horizontal transfer driving signal are applied to the vertical transfer portions 2 and the horizontal transfer portion 4, respectively, so that vertical and horizontal charge transfers are performed in the solid state image pickup device. By means of these driving signals, signal charges produced in the photodetectors 1 in response to light received thereby during, for example, one frame period, are read out to the vertical transfer portions 2 and then transferred vertically towards the horizontal transfer portion 4 by charge transfer operation of the vertical transfer portions 2 during each horizontal blanking period so that the signal charges produced in each horizontal row of the photodetectors 1 are transferred in turn to the horizontal transfer portion 4. The signal charges transferred to the horizontal transfer portion 4 are further transferred horizontally to the output portion 5 by charge transfer operation of the horizontal transfer portion 4 during each horizontal video period and, as a result of this, an image pickup signal output is obtained at the signal output terminal 5a.

Going into more detail, the photo-sensing and vertical transfer portion 3 contains transfer gate areas 6 provided between the photodetectors 1 of each vertical row and the corresponding one of the vertical transfer portions 2 and a channel stop area 7 provided around each of the photodetectors 1, as shown in Figure 2A. Further, an overflow drain 8 is contiguous with each of the channel stop areas 7 and each of the overflow drains 8 and a corresponding one of the vertical transfer portions 2 is separated by a channel stop area 9. On the vertical transfer portions 2, vertical transfer electrodes $\Phi_1$ and $\Phi_2$, each extending in the horizontal direction, are provided alternately in the vertical direction. Each vertical transfer electrode $\Phi_1$ is composed of a charge storage electrode $\Phi_{1c}$ and a charge transfer electrode (potential barrier electrode) $\Phi_{1t}$, and each vertical transfer electrode $\Phi_2$ is composed of a charge storage electrode $\Phi_{2c}$ and a charge transfer electrode $\Phi_{2t}$. In the vertical transfer portions 2, storage regions are formed under the charge storage electrodes $\Phi_{1c}$ and $\Phi_{2c}$ and transfer regions (potential barrier regions) are formed under the charge transfer electrodes $\Phi_{1t}$ and $\Phi_{2t}$, and each transfer region is subjected to ion implantation or has a thick insulating layer provided thereon so as to have a potential which is shallower (less) than that of the storage region adjacent thereto and to form a potential barrier. As shown in Figure 2B, which is a sectional view at a position indicated by arrows IIB—IIB in Figure 2A, the above-mentioned portions and areas are formed on a semiconductor substrate 10 (which is, for example, a P-type substrate), an insulating layer 11 covers the whole of these portions and areas and the vertical transfer electrodes ($\Phi_2$) are provided on the layer 11. In this example, the vertical transfer electrodes $\Phi_1$ and $\Phi_2$ include transfer gate electrodes at portions thereof. Therefore, in Figure 2B, the vertical transfer electrode $\Phi_2$ (more exactly the charge storage electrode $\Phi_{2c}$ of the vertical transfer electrode $\Phi_2$) is extended to cover the transfer gate area 6.

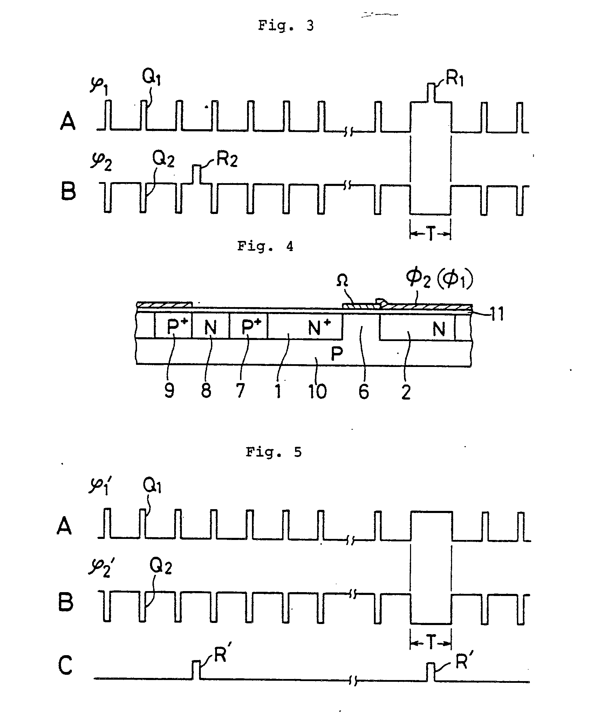

In the previously proposed solid state image pickup apparatus employing a solid state image pickup device of the interline transfer type constituted as just described, the vertical transfer electrodes $\Phi_1$ and $\Phi_2$ on the photo-sensing and vertical transfer portion 3 of the solid state image pickup device are supplied with driving signals $\varphi_1$ and $\varphi_2$ as shown in Figures 3A and 3B, respectively, and the voltages of the driving signals $\varphi_1$ and $\varphi_2$ are applied to the transfer gate areas 6 and the vertical transfer portions 2 positioned under the vertical transfer electrodes $\Phi_1$ and $\Phi_2$. By means of the driving signals $\varphi_1$ and $\varphi_2$, the signal charges stored in each two photodetectors 1 adjacent vertically to each other are read out through the transfer gate areas 6 to the vertical transfer portions 2 from one of the two photodetectors 1 alternately at every field period so that the signal charges obtained in the photodetectors 1 are read out in a frame interlaced reading manner, and the signal charges read out to the vertical transfer portions 2 are transferred vertically to the horizontal transfer portion 4. To achieve such operation, the driving signals $\varphi_1$ and $\varphi_2$ have reading pulses $R_1$ and $R_2$ of high level appearing at every frame period, respectively, and also have transfer pulses $Q_1$ and $Q_2$ of opposite phases appearing at each horizontal blanking period, respectively. The signal charges are transferred vertically with the high level of the transfer pulse $Q_1$ and the low level of the transfer pulse $Q_2$.

When the reading pulse $R_2$ of the driving signal $\varphi_2$ is supplied to the vertical transfer electrodes $\Phi_2$, the voltage of the reading pulse $R_2$ is applied to a first group of the transfer gate areas 6 under the vertical transfer electrodes $\Phi_2$ and the signal charges stored during one frame period in the photodetectors 1 corresponding to the first group of the transfer gate areas 6 are read out to the vertical transfer portions 2 as signal charges for the first field. Then, the signal charges read out to the vertical transfer portions 2 in response to the reading pulse $R_2$ are transferred vertically at each horizontal blanking period according to the voltages of the transfer pulses $Q_1$ and $Q_2$ applied to the vertical transfer portions 2 under the vertical transfer electrodes $\Phi_1$ and $\Phi_2$. After that, when the reading pulse $R_1$ of the driving signal $\varphi_1$ is supplied to the vertical transfer electrodes $\Phi_1$, the voltage of the reading pulse $R_1$ is applied to a second group of the transfer gate areas 6 under the vertical transfer electrodes $\Phi_1$ and the signal charges stored during one frame period in the photodetectors 1 corresponding to the second group of the transfer gate areas 6 are read out to the vertical transfer portions 2 as signal charges for the second field. Then, the signal charges read out to the vertical transfer portions 2 in response to the reading pulse $R_1$ are transferred vertically at each horizontal blanking period according to the voltages of the transfer pulses $Q_1$ and $Q_2$ applied to the vertical transfer portions 2 under the vertical transfer electrodes $\Phi_1$ and $\Phi_2$. The reading and transferring operation mentioned above is performed repeatedly.

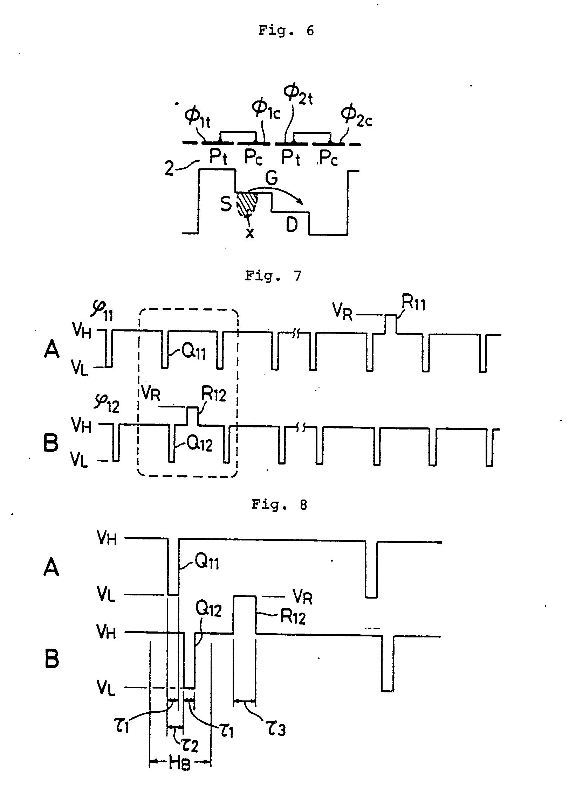

In the case of a variant of the previously proposed solid state image pickup apparatus employing a solid state image pickup device of the interline transfer type in which independent transfer gate electrodes $\Omega$ are provided as shown in Figure 4, two-level driving signals $\varphi_1'$ and $\varphi_2'$ having the transfer pulses $Q_1$ and $Q_2$, respectively, as shown in Figures 5A and 5B, respectively, are supplied to the vertical transfer electrodes $\Phi_1$ and $\Phi_2$, respectively, and a reading pulse $R'$ appearing at every field period as shown in Figure 5C is supplied to the transfer gate electrodes $\Omega$. When the reading pulse $R'$ is supplied to the transfer gate electrodes $\Omega$, the signal charges in the photodetectors 1 corresponding to the transfer gate areas 6 which are contiguous to the regions in the vertical transfer portions 2 to which the voltage of the high level of either the driving signal $\varphi_1'$ or $\varphi_2'$ is applied are read out to the vertical transfer portions 2. The vertical transfer of the signal charges is carried out in response to the transfer pulses $Q_1$ and $Q_2$ in the same manner as in the device shown at Figures 2A and 2B.

When a picture is reproduced in response to the image pickup signal output obtained at the signal output terminal 5a of the solid state image pickup device employed in the previously proposed solid state image pickup apparatus as described above, the reproduced picture is subjected to the above-mentioned white and black spots defect which is caused by a local area of deep potential, that is, a local area with abnormally deep potential formed in the vertical transfer portions 2 of the solid state image pickup device. Figure 6 shows a situation in which such a local area of deep potential, which will cause the white and black spots to occur, is formed undesirably. In Figure 6, steps in the storage regions $P_c$ and the transfer regions $P_t$ under the charge storage electrodes $\Phi_{1c}$ and $\Phi_{2c}$ and the charge transfer electrodes $\Phi_{1t}$ and $\Phi_{2t}$, which form the vertical transfer electrodes $\Phi_1$ and $\Phi_2$, represent the depth of potential of the respective regions in the process of charge transfer in the vertical transfer portion 2, which increases downwardly, and $x$ indicates the local area of deep potential formed undesirably in the vertical transfer portion 2. What happens is that a MOS FET having its source S constituted by the area $x$, its gate G constituted by the storage region $P_c$ under the charge storage electrode $\Phi_{1c}$ and its drain D constituted by the transfer region $P_t$ under the charge transfer electrode $\Phi_{2t}$ is substantially formed, and a flow of charges arises from the area $x$ under the vertical transfer electrode $\Phi_1$ to an advanced potential well in the regions under the vertical transfer electrode $\Phi_2$ as a sub-threshold current of the MOS FET. If a charge transfer period in which each charge transfer in the vertical transfer portion 2 is carried out is constant and the interval between such charge transfer periods is made uniform, the amount of charges flowing from the area $x$ to the advanced potential well is not varied and, therefore, the charges flowing into the advanced potential well do not raise any troublesome problem. However, as described above, the charge transfer in the vertical transfer portion 2 is carried out in response to the driving signals $\varphi_1$ and $\varphi_2$ shown in Figures 3A and 3B or the driving signals $\varphi_1'$ and $\varphi_2'$ shown in Figures 5A and 5B, and consequently, a long charge transfer period T appears once per frame period, as shown in Figures 3A and 3B and in the Figures 5A and 5B. In the case of these driving signals, the long charge transfer period T appears to include a reading out period in which the signal charges for the second field are read out to the vertical transfer portion 2. During this long charge transfer period T, the area $x$ transfers the charges stored therein in large quantities compared with the normal amount of charges to the advanced potential well so as to supply excessive signal charges to the latter and, on the contrary, to make the regions positioned behind lack signal charges. This causes the white and black spots to occur in such a manner as described above.

Preferred embodiments of the present invention will now be described in detail.

One example of a solid state image pickup apparatus embodying the present invention is constituted by a solid state image pickup device having the configuration shown in Figures 1, 2A and 2B and means for supplying two-phase driving signals $\varphi_{11}$ and $\varphi_{12}$ as shown in Figures 7A and 7B to the vertical transfer electrodes $\Phi_1$ and $\Phi_2$ of the solid state image pickup device, respectively. The driving signals $\varphi_{11}$ and $\varphi_{12}$ are each formed as three-level signals. The driving signal $\varphi_{11}$ contains a reading pulse $R_{11}$ of a first high level $V_R$ and a transfer pulse $Q_{11}$ of a low level $V_L$ appearing in each horizontal blanking period, and adopts a second high level $V_H$, lower than the first high level $V_R$, during each horizontal video period. The driving signal $\varphi_{12}$ contains a reading pulse $R_{12}$ of the first high level $V_R$ and a transfer pulse $Q_{12}$ of the low level $V_L$ appearing in each horizontal blanking period, and adopts the second high level $V_H$ during each horizontal video period. The transfer pulses $Q_{11}$ and $Q_{12}$ take up respective phases that are different from each other in each horizontal blanking period.

Figure 8 shows an enlarged scale the portions of the driving signals $\varphi_{11}$ and $\varphi_{12}$ encircled by a broken line in Figures 7A and 7B. As shown in Figure 8, the transfer pulses $Q_{11}$ and $Q_{12}$, each of which has a pulse width $\tau_1$ of about 2 microseconds, appear within the horizontal blanking period $H_B$ with a time difference $\tau_2$ of about 3 microseconds between them, and each of the reading pulses $R_{11}$ and $R_{12}$ has a pulse width $\tau_3$ of about 20 microseconds. When the driving signals $\tau_{11}$ and $\tau_{12}$ are supplied, the voltage having the second high level $V_H$ is applied to the storage regions of the vertical transfer portions 2 under the charge storage electrodes $\Phi_{1c}$ and $\Phi_{2c}$ and the transfer regions of the vertical transfer portions 2 under the charge transfer electrodes $\Phi_{1t}$ and $\Phi_{2t}$ during each horizontal video period, and the charge transfer in the vertical transfer portions 2 is carried out when the voltage having the low level $V_L$ of the transfer pulse $Q_{11}$ is first applied to the regions under the vertical transfer electrodes $\Phi_1$ and then the voltage having the low level $V_L$ of the transfer pulse

$Q_{12}$ is applied to the regions under the vertical transfer electrodes $\Phi_2$ within each horizontal blanking period.

The transfer of signal charges from the photodetectors 1 to the vertical transfer portions 2 is performed as described below.

When the reading pulse $R_{12}$ of the driving signal $\varphi_{12}$ is supplied to the vertical transfer electrodes $\Phi_2$, the voltage having the first high level $V_R$ of the reading pulse $R_{12}$ is applied to the transfer gate areas 6 under the charge storage electrodes $\Phi_{2c}$ and the signal charges stored during one frame period in the photodetectors 1 corresponding to the transfer gate areas 6 under the charge storage electrodes $\Phi_{2c}$ are read out to the storage regions of the vertical transfer portions 2 under the charge storage electrodes $\Phi_{2c}$ as signal charges for the first field. After that, when the reading pulse $R_{11}$ of the driving signal $\varphi_{11}$ is supplied to the vertical transfer electrodes $\Phi_1$, the voltage having the first high level $V_R$ of the reading pulse $R_{11}$ is applied to the transfer gate areas 6 under the charge storage electrodes $\Phi_{1c}$ and the signal charges stored during one frame period in the photodetectors 1 corresponding to the transfer gate areas 6 under the charge storage electrodes $\Phi_{1c}$ are read out to the storage regions of the vertical transfer portions 2 under the charge storage electrodes $\Phi_{1c}$ as signal charges for the second field. This reading operation is performed repeatedly and, as a result, the signal charges obtained in the photodetectors 1 are read out in a frame interlaced manner.

The amplitude $(V_R - V_H)$ of each of the reading pulses $R_{11}$ and $R_{12}$ is selected to be smaller than the amplitude $(V_H - V_L)$ of each of the transfer pulses $Q_{11}$ and $Q_{12}$, so that the reading pulse $R_{11}$ or $R_{12}$ is prevented from making such potential steps in the vertical transfer portions 2 as will cause charge transfer in the vertical transfer portions 2.

In addition, it is preferable to provide a vertical output gate portion at the end of each of the vertical transfer portions 2 and make the vertical output gate portions be in the ON state in response to the transfer pulse $Q_{11}$ and $Q_{12}$ so as to transfer the signal charges to the horizontal transfer portion 4 from the vertical transfer portions 2, in order to prevent the signal charges in the process of transfer in the horizontal transfer portion 4 from flowing into the vertical transfer portions 2.

As described above, with the two-phase driving signals $\varphi_{11}$ and $\varphi_{12}$ supplied to the vertical transfer electrodes $\Phi_1$ and $\Phi_2$, the signal charges obtained in the photodetectors 1 are read out to the vertical transfer portions 2 in a frame interlaced manner. Further, since the signal charges read out to the vertical transfer portions 2 are transferred in the vertical transfer portions 2 only during the periods of the transfer pulses $Q_{11}$ and $Q_{12}$ within each horizontal blanking period, the charge transfer period in which each charge transfer in the vertical transfer portions 2 is carried out is kept constant and the interval between such charge transfer periods is made uniform and, as a result of this, an image pickup signal output from which a picture which does not contain the white and black spots can be reproduced can be obtained at the signal output terminal 5a.

Although a solid state image pickup device having vertical transfer portions which are driven to be operative by two-phase driving signals is employed in the embodiment described above, a solid state image pickup device having vertical transfer portions which are arranged to be driven by four-phase driving signals can be used in a solid state image pickup apparatus in accordance with the present invention.

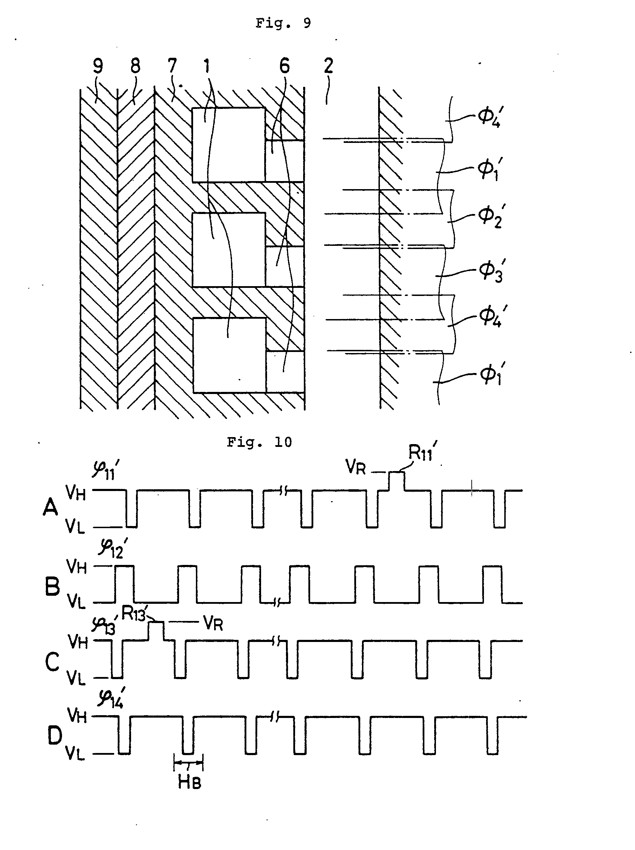

Figure 9 shows the configuration of a photosensing and vertical transfer portion in a solid state image pickup device employed in another embodiment of the present invention which has vertical transfer portions which are arranged to be driven by four-phase driving signals.

In Figure 9, portions and areas corresponding to portions of Figure 2A are designated by the same references. In this case, vertical transfer electrodes $\Phi_1'$, $\Phi_2'$, $\Phi_3'$ and $\Phi_4'$ are independent and arranged in order repeatedly. The vertical transfer electrodes $\Phi_1'$ and $\Phi_3'$ include respective transfer gate electrodes at portions thereof.

Figures 10A, 10B, 10C and 10D show four-phase driving signals $\varphi_{11}'$, $\varphi_{12}'$, $\varphi_{13}'$ and $\varphi_{14}'$ which are supplied to the vertical transfer electrodes $\Phi_1'$, $\Phi_2'$, $\Phi_3'$ and $\Phi_4'$, respectively, of the device shown in Figure 9.

With such four-phase driving signals $\varphi_{11}'$, $\varphi_{12}'$, $\varphi_{13}'$ and $\varphi_{14}'$, in the vertical transfer portions 2, the storage regions are formed under the vertical transfer electrodes $\Phi_1'$, $\Phi_3'$ and $\Phi_4'$ and the transfer regions are formed under the vertical transfer electrodes $\Phi_2'$. The signal charges obtained in the photodetectors 1 are read out to the vertical transfer portions 2 at every field period in a frame interlaced manner in response to reading pulses $R_{11}'$ and $R_{13}'$ of the first high level $V_R$ and contained in the driving signals $\varphi_{11}'$ and $\varphi_{13}'$, respectively, and the voltage having the second high level $V_H$ is applied to the storage regions in the vertical transfer portions 2 during each horizontal video period.

Although, in this embodiment, the voltage having the low level $V_L$ of the driving signal $\varphi_{12}'$ is applied only to the transfer regions of the vertical transfer portions 2 under the vertical transfer electrodes $\Phi_2'$ during each horizontal video period, it is also possible to arrange the device so that the transfer regions of the vertical transfer portions 2 are formed under the vertical transfer electrodes $\Phi_4'$ and the voltage having the low level $V_L$ is applied to the transfer regions under the vertical transfer electrodes $\Phi_4'$ during each horizontal video period.

In this embodiment, the charge transfer in the vertical transfer portions 2 is carried out when the driving signal $\varphi_{12}'$ adopts the second high level $V_H$ and the transfer pulses of the low level $V_L$ and contained in the driving signals $\Phi_{11}'$, $\Phi_{13}'$ and $\Phi_{14}'$, respectively, appear with respective different phases within each horizontal blanking period. When the charge transfer operation is performed in the vertical transfer portions 2, the voltage having the second high level $V_H$ is applied to the regions in the vertical transfer portions 2 under two or three adjacent ones of the vertical transfer electrodes $\Phi_1'$ to $\Phi_4'$ simultaneously so that a potential well is formed in turn in these regions. This results in increased charge transfer efficiency. The amplitude $(V_R - V_H)$ of each of the reading pulses $R_{11}'$ and $R_{13}'$ is selected to be smaller than the amplitude $(V_H - V_L)$ of each of the transfer pulses appearing in the horizontal blanking period for the same reason as mentioned above.

In this case also, the charge transfer period in which each charge transfer in the vertical transfer portions 2 is carried out is kept constant and the interval between the charge transfer periods is made uniform and, consequently, it is possible to obtain an image pickup signal output from which a picture which does not include the white and black spots can be reproduced.

The solid state image pickup apparatus embodying the present invention and described above can produce an image pickup signal output which is superior in quality, from which a picture which does not have the white and black spots thereon can be reproduced, and therefore is quite suitable for constituting a high-grade television camera which is miniaturised and lightweight.

**Claim**

A solid state image pickup apparatus comprising:

a solid state image pickup device which comprises a plurality of photodetectors (1) arranged horizontally and vertically, a plurality of transfer gate areas (6) each corresponding to one of the photodetectors (1), a plurality of vertical transfer portions (2) each extending vertically and positioned contiguously to the transfer gate areas (6) to receive signal charges transferred from alternate rows of the photodetectors (1) spaced in the vertical direction during successive field periods, an output portion (5), and a horizontal transfer portion (4) coupled to an end of each of the vertical transfer portions (2) to receive the signal charges from the vertical transfer portions (2) and to transfer the charges to the output portion (5); and

means for generating a signal ($\varphi_{11}$, $\varphi_{12}$; $\varphi_{11}'$, $\varphi_{12}'$, $\varphi_{13}'$, $\varphi_{14}'$) to cause transfer of the signal charges from the photodetectors (1) to the vertical transfer portions (2) and thence to the horizontal transfer portion (4);

characterised in that the signal generating means is operative such that a reading pulse voltage of a first high level $(V_R)$ is applied to each of two of the transfer gate areas (6) adjacent in the vertical direction alternately at every field period so that signal charges are read out to storage regions of the vertical transfer portions (2) from the photodetectors (1) corresponding to the transfer gate areas (6) to which the reading pulse voltage is applied, a voltage of a second high level ($V_H$) lower than the first high level ($V_L$) is applied to the storage regions of the vertical transfer portions (2) during each horizontal video period, and transfer pulse voltages ($Q_{11}$, $Q_{12}$), adopting a low level in turn at respective different phases within each horizontal blanking period ($H_B$) are applied to the vertical transfer portions (2) so that the signal charges read out to the vertical transfer portions (2) are transferred vertically to the horizontal transfer portion (4).

### Anspruch

Integrierte Bildaufnahmevorrichtung mit
einer Festkörper-Bildaufnahmeeinrichtung, die eine Vielzahl von Photodetektoren (1), welche horizontal und vertikal angeordnet sind, eine Vielzahl von Transfergate-Flächen (6), wovon jede mit einem der Photodetektoren (1) korrespondiert, eine Vielzahl von vertikalen Transferabschnitten (2), wovon sich jeder vertikal erstreckt und angrenzend an die Transfergate-Flächen (6) angeordnet ist, um Signalladungen aufzunehmen, die von den sich abwechselnden Reihen der Photodetektoren (1), welche in vertikaler Richtung einen Abstand voneinander aufweisen, während aufeinanderfolgender Teilbildperioden übertragen werden, einen Ausgangsabschnitt (5) und einen horizontalen Transferabschnitt (4), der mit einem Ende jedes der vertikalen Transferabschnitte (2) verbunden ist, um die Signalladungen von den vertikalen Transferabschnitten (2) aufzunehmen und die Ladungen zu dem Ausgangsabschnitt (5) zu übertragen, enthält und
Mitteln zum Erzeugen eines Signals ($\varphi_{11}$, $\varphi_{12}$; $\varphi_{11'}$, $\varphi_{12'}$, $\varphi_{13'}$, $\varphi_{14'}$) zum Bewirken der Übertragung der Signalladungen von den Photodetektoren (1) zu den vertikalen Transferabschnitten (2) und dan zu dem horizontalen Transferabschnitt (4), dadurch gekennzeichnet, daß die Signalerzeugungsmittel derart betreibbar sind, daß eine Leseimpulsspannung mit einem ersten hohen Pegel ($V_R$) an jede von zwei der Transfergate-Flächen (6), die in der vertikalen Richtung einander benachbart sind, abwechselnd bei jeder Teilbildperiode gelegt wird, so daß Signalladungen zu Speicherbereichen der vertikalen Transferabschnitte (2) aus den Photodetektoren (1), die mit den Tranfergate-Flächen (6) korrespondieren, an die die Leseimpulsspannung gelegt wird, ausgelesen werden, eine Spannung mit einem zweiten hohen Pegel ($V_H$), der niedriger als der erste hohe Pegel ($V_L$) ist, an die Speicherbereiche der vertikalen Transferabschnitte (2) während jeder Horizontal-Videoperiode gelegt wird, und Über-

tragungsimpulsspannungen ($Q_{11}$, $Q_{12}$), die der Reihe nach bei den jeweiligen unterschiedlichen Phasen innerhalb jeder Horizontalausperiode ($H_B$) einem niedrigen Pegel annehmen, an die vertikalen Transferabschnitte (2) gelegt werden, so daß die Signalladungen, die zu den vertikalen Transferabschnitten (2) ausgelesen wurden, in vertikaler Richtung zu dem horizontalen Transferabschnitt (4) übertragen werden.

### Revendication

1. Appareil de prise de vues à semi-conducteurs, comportant: un dispositif analyseur d'images à semi-conducteurs qui comprend plusieurs photodétecteurs (1) disposés horizontalement et verticalement, plusieurs régions de grilles de transfert (6) correspondant chacune à l'un des photodétecteurs, plusieurs parties de transfert vertical (2) disposées chacune verticalement et positionnées contre les régions de grilles de transfert (6) pour recevoir des charges de signaux transférées par des rangées alternées des photodétecteurs (1) espacées dans la direction verticale pendant des périodes de trames successives, une partie de sortie (5) et une partie de transfert horizontal (4) couplée avec une extrémité de chacune des parties de transfert vertical (2) pour en recevoir les charges de signaux et pour transférer les charges à la partie de sortie (5); et un dispositif générateur d'un signal ($\varphi_{11}$, $\varphi_{12}$; $\varphi'_{11}$, $\varphi'_{12}$, $\varphi'_{13}$, $\varphi'_{14}$) qui entraîne le transfert des charges de signaux depuis les photodétecteurs (1) vers les parties de transfert vertical (2) et, de là, vers la partie de transfert horizontal (4); caractérisé en ce que le dispositif générateur de signaux fonctionne de façon qu'une impulsion de tension de lecture d'un premier niveau haut ($V_R$) soit appliquée à chacune de deux des régions de grilles de transfert (6) voisines dans la direction verticale alternativement à chaque période de trame de façon que les charges de signaux soient lues dans des régions d'emmagasinage des parties de transfert vertical (2) à partir des photodétecteurs (1) correspondant aux régions de grilles de transfert (6) auxquelles l'impulsion de tension de lecture est appliquée, une tension d'un second niveau haut $V_H$ inférieur au premier niveau haut $V_L$ étant appliquée aux régions d'emmagasinage des parties de transfert vertical (2) pendant chaque période vidéo horizontale et des impulsions de tension de transfert ($Q_{11}$, $Q_{12}$) passant à un niveau bas tour à tour à des phases différentes respectives dans chaque période de blocage horizontal ($H_B$) étant appliquées aux parties de transfert vertical (2) de manière que les charges de signaux lues dans les parties de transfert vertical (2) soient transférées verticalement dans la partie de transfert horizontal (4).

Fig. 1

Fig.2

A

IIB

IIB

$\phi_{1t}$
$\phi_{1c}$  $\phi_1$
$\phi_{2t}$
$\phi_{2c}$  $\phi_2$
$\phi_{1t}$

B

$\phi_2$

11

| $P^+$ | N | $P^+$ | $N^+$ | | P | | N | |
| 9 | 8 | 7 | 1 | 10 | | 6 | 2 | |

1

Fig. 3

Fig. 4

Fig. 5

Fig. 6

Fig. 7

Fig. 8

3

0 088 134

Fig. 9

Fig. 10

4